# EUROPÄISCHE PATENTSCHRIFT

(11) **EP 1 882 401 B1**
(45) Veröffentlichungstag und Bekanntmachung des Hinweises auf die Patenterteilung: **13.06.2012**
(21) Anmeldenummer: 06707884.0
(22) Anmeldetag: 30.01.2006
(51) Int. Cl.: H05K 1/14, H05K 5/00, H05K 1/18

(54) **STEUEREINHEIT MIT EINER FLEXIBLEN LEITERPLATTE**
CONTROL UNIT COMPRISING A FLEXIBLE CIRCUIT BOARD
UNITE DE COMMANDE COMPRENANT UNE CARTE DE CIRCUITS IMPRIMES SOUPLE

(30) Priorität: 17.05.2005 DE 102005022536
(43) Veröffentlichungstag der Anmeldung: 30.01.2008
(73) Patentinhaber: Continental Automotive GmbH, 30165 Hannover (DE)
(72) Erfinder: HAUER, Gerald, 93180 Deuerling (DE); LOIBL, Josef, 93077 Bad Abbach (DE); RÖHRL, Thomas, 93092 Barbing (DE); VOGEL, Mike, 93049 Regensburg (DE)
(86) Internationale Anmeldenummer: PCT/EP2006/050505
(87) Internationale Veröffentlichungsnummer: WO 2006/122837

(56) Entgegenhaltungen:
- DE-C1- 10 051 945
- US-A- 4 510 551
- US-A1- 2002 148 631
- US-A1- 2004 045 736
- US-A1- 2004 073 349

## Beschreibung

Die vorliegende Erfindung betrifft eine Steuereinheit mit einer flexiblen Leiterplatte nach dem Oberbegriff des Patentanspruchs 1.

Automatikgetriebe für Kraftfahrzeuge werden vornehmlich elektronisch gesteuert. Während dafür bisher Stand-Alone-Steuergeräte zum Verbau in eine vor Umwelteinflüssen schützende Box oder in den Passagierraum vorgesehen waren, setzt sich der Trend zur Integration der Steuerelektronik und der zugehörigen Sensorik in das Getriebe zugunsten einer mechatronischen Getriebesteuerung weiter fort. Ähnliche Trends für Vorortelektronik gibt es auch in anderen Bereichen, wie z. B. Motorensteuerungen und Bremssystemen. Um die Signale und Ströme an die gewünschten Orte zu verteilen, werden unter anderem flexible Leiterplatten eingesetzt.

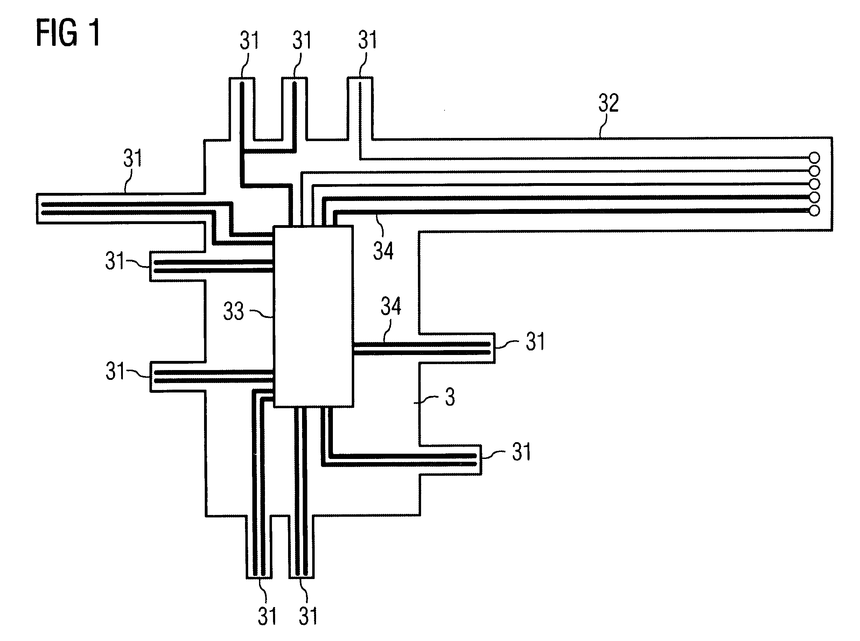

Figur 1 zeigt den Aufbau einer herkömmlichen flexiblen Leiterplatte im Grundriss, wie sie in aktuellen Serienanwendungen mechatronischer Getriebesteuerungen zur Verteilung von elektrischen Signalen und Strömen verwendet wird. Die flexible Leiterplatte 3 besteht aus einer isolierenden Basisfolie und einer isolierenden Deckfolie aus Polyimid, dazwischen eingebettet befinden sich leitende Kupferbahnen (nicht dargestellt). Durch den Einsatz eines Acryl-Klebers zwischen den Schichten entsteht eine feste Einheit. In einem Innenbereich der flexiblen Leiterplatte 3 ist für die starre Leiterplatte 5 mit der Elektronik ein rechteckiger Bereich als Aussparung 33 ausgebildet. In diesem Bereich wird später die komplett bestückte und getestete starre Leiterplatte 5 mit Wärmeleitkleber auf eine Grundplatte auflaminiert und mittels Bondtechnik zu den Leiterbahnen 34 der flexiblen Leiterplatte 3 elektrisch angebunden. Von der Aussparung 33 aus führen Leiterbahnen 34 weg. Die Leiterbahnen 34 sind normalerweise gruppiert in Leiterbahnen 31 zu Aktuatoren und Sensoren und Leiterbahnen 32 zu einem Kabelbaum.

Dem Einsatz im Getriebeöl muss eine flexible Leiterplatte über die gesamte Lebensdauer standhalten. Aus Kostengründen wird der Einsatz einlagiger flexibler Leiterplatten bevorzugt. Es können einteilige oder mehrteilige (Teilflex-Lösung) flexible Leiterplatten eingesetzt werden.

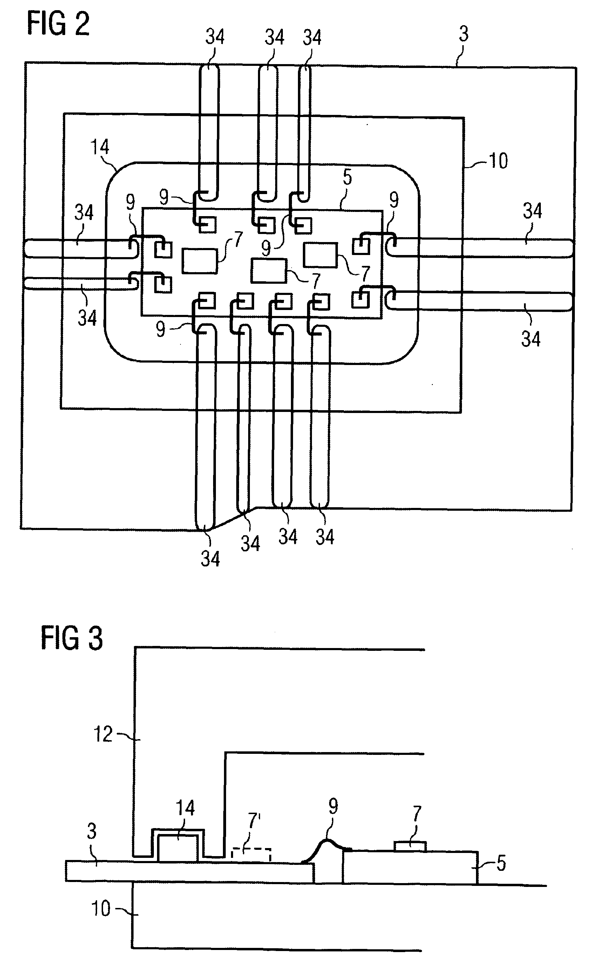

Figur 2 zeigt den Aufbau einer herkömmlichen Getriebesteuerung im Grundriss. Eine starre Leiterplatte 5 ist auf einer Grundplatte 10 befestigt. Eine flexible Leiterplatte 3 mit Leiterbahnen 34 ist über Bondverbindungen 9 an die starre Leiterplatte 5 angeschlossen. Sämtliche elektronischen Bauteile 7 sind auf der starren Leiterplatte 5 angeordnet. Eine Dichtung 14 zusammen mit einem Deckel 12 schirmt die starre Leiterplatte 5 und einen Teil der flexiblen Leiterplatte 3 von der Umgebung ab.

Die starre Leiterplatte 5 wird aus einem Substrat gefertigt und basiert beispielsweise auf einer Standardleiterplatte, auf low temperature cofired ceramics (LTCC), oder auf Dickfilm-Technologie. Die Herstellung solcher Substrate ist sehr teuer und aufwändig, da sie unter anderem hohen Beschleunigungen bis über 30-fache Erdbeschleunigung standhalten müssen.

Aus EP 0972 318 B1 ist zudem eine Anordnung für eine elektrische Verbindung eines Schaltungsträgers mit einem Leiterbahnträger bekannt. In einem Überlappungsbereich zwischen dem Schaltungsträger und dem Leiterbahnträger ist der Leiterbahnträger auf einer Grundplatte angeordnet und der Schaltungsträger auf dem Leiterbahnträger angeordnet. Der Schaltungsträger ist im Überlappungsbereich mittels eines elektrisch leitenden Klebers mit dem Leiterbahnträger elektrisch verbunden.

Das Dokument DE 100 51 945 C1 offenbart eine Steuereinheit für eine Fahrzeugkomponente, umfassend eine flexible Leiterplatte und eine starre Leiterplatte, welche mit elektronischen Bauelementen bestückt ist, wobei die flexible Leiterplatte mit der starren Leiterplatte elektrisch verbunden ist. Die starre Leiterplatte und ein Teil der flexiblen Leiterplatte sind in einem Gehäuse angeordnet. Die flexible Leiterplatte ist durch das Gehäuse hindurchgeführt.

Das Dokument US 2004/045736 A1 offenbart eine Steuereinheit für eine Fahrzeugkomponente, umfassend eine flexible Leiterplatte und eine starre Leiterplatte, welche mit elektronischen Bauteilen bestückt ist. Die flexible Leiterplatte ist mit der starren Leiterplatte elektrisch verbunden. Die starre Leiterplatte und die flexible Leiterplatte sind in einem Gehäuse angeordnet. Die flexible Leiterplatte im Inneren des Gehäuses ist mit elektronischen Bauteilen bestückt.

Nachteilig an den bestehenden Steuereinheiten mit einer flexiblen und einer starren Leiterplatte ist, dass diese aufwändig in der Herstellung und daher teuer sind.

Der vorliegenden Erfindung liegt daher die Aufgabe zugrunde, eine Steuereinheit mit reduzierten Produktionskosten zu ermöglichen.

Diese Aufgabe wird durch die im Patentanspruch 1 angegebenen Maßnahmen gelöst. Vorteilhafte Ausgestaltungen der Erfindung sind in weiteren Ansprüchen angegeben.

Dadurch dass die flexible Leiterplatte im Innern des Gehäuses mit elektronischen Bauteilen bestückt ist, können die Produktionskosten reduziert werden. Insbesondere wird weniger Material für das teure Substrat der starren Leiterplatte benötigt, da die Fläche der starren Leiterplatte reduziert werden kann, indem Bauteile von der starren Leiterplatte auf die flexible Leiterplatte ausgelagert werden.

Indem die starre Leiterplatte in einem Gehäuse angeordnet ist und die flexible Leiterplatte durch das Gehäuse hindurchgeführt ist, kann die starre Leiterplatte und ein Teil der flexiblen Leiterplatte vor chemischen und/oder mechanischen und/oder elektrischen Umgebungseinflüssen geschützt werden.

Eine Anordnung von Bauteilen innerhalb des Gehäuses ist daher besonders vorteilhaft. Auf diese Weise lassen sich auch Bauteile auf die flexible Leiterplatte auslagern, welche den Bedingungen außerhalb des schützenden Gehäuses nicht standhalten würden.

Durch eine solche Anordnung erhöhen sich die konstruktiven Freiheiten in der Gestaltung des Gerätedesigns und insbesondere des Elektronikraums. Auch wird ein Einsatz günstigerer Bauteile möglich. Bauteile mit verzinnter Padbeschichtung sind geeignet für Lötverbindungen während AgPd-Beschichtung bei einem Verbau auf dem Substrat geeignet für Silberleitkleben ist.

Eine einfache Variantenbildung durch Teilbestückung auf der flexiblen Leiterplatte ist möglich, insbesondere wenn auf der flexiblen Leiterplatte Platz für mehrere Bauteile vorgesehen ist, welcher lediglich für spezielle Varianten bestückt wird. Einen großen Vorteil gewinnt man dadurch, dass keine teuere Substrat-Fläche bei Varianten mit Minderbestückung vorgehalten werden muss und man so ein Einheitssubstrat verwenden kann. Dadurch ergibt sich auch eine Verkürzung der Entwicklungszeit bei Verwendung eines Substrats mit fester Bestückung und Variantenbildung in den Schaltungsteilen auf der flexiblen Leiterplatte, da die Aufbauzeit eines geänderten Layouts der flexiblen Leiterplatte sehr kurz ist,

Innerhalb oder außerhalb des Gehäuses können auf der flexiblen Leiterplatte auch gehäuste und ungehäuste Bauteile, wie Hallsensoren zur Drehzahlmessung verwendet werden. Teure einzeln verpackte Sensoren sind daher nicht mehr notwendig, sondern können einfach in die mechatronische Steuerung integriert werden.

Die thermische Anbindung kritischer Schaltungsteile bzw. kritischer Bauteile (z.B. Endstufen oder Spannungsregler) kann verbessert werden.

Die folgenden Vorteile können sich zusätzlich ergeben:

Nicht alle Bauteile sind gleichermaßen für eine Auslagerung auf die flexible Leiterplatte geeignet. Geeignet sind grundsätzlich Funktionsblöcke, die möglichst wenige zusätzliche Bondverbindungen zwischen der starren und der flexiblen Leiterplatte erzeugen. Auch lassen sich die Leiterbahnen von starren Leiterplatten in kleineren Dimensionen ausgestalten, als die Leiterbahnen von flexiblen Leiterplatten. Tendenziell lassen sich daher Bauteile mit nicht allzu eng zusammenliegenden und nicht allzu vielen Anschlüssen einfacher in die flexible Leiterplatte auslagern, da auf der flexiblen Leiterplatte die Leiterbahnen nicht beliebig eng aneinander liegen können.

Zudem ist die starre Leiterplatte in der Praxis meist auf einer Bodenplatte mit einer hohen Wärmeleitfähigkeit, beispielsweise auf einer Aluminiumplatte, angebracht, wodurch eine gute Wärmeabfuhr ebenfalls gewährleistet ist.

Aufgrund obiger Ausführungen ist daher ist die Auslagerung von Kondensatoren, Transistoren, Widerständen, Sensoren, Hallsensoren und Spannungsregler auf die flexible Leiterplatte besonders vorteilhaft.

Für einzelne Bauteile, wie Hallsensoren zur Drehzahlmessung, kann eine Bestückung außerhalb des Gehäuses von Vorteil sein. Insbesondere für den Einsatz der Steuereinheit in einer mechanisch und chemisch beanspruchenden Umgebung, wie zum Beispiel in einem Fahrzeuggetriebe, lässt sich die Elektronik, mithilfe eines öldichten Gehäuses, durch welches die flexible Leiterplatte hindurchgeführt ist, vor einer Zerstörung bewahren.

Eine flexible Leiterplatte mit einer isolierenden Basisschicht und einer isolierenden Deckschicht mit Aussparungen, auf welchen Bauteile angeordnet sind, ist besonders einfach herzustellen und einzubauen. Durch die isolierenden Schichten sind keine weiteren Isolationen notwendig und auf den Aussparungen können Bauteile angelötet, angeschweißt oder angeklebt werden.

Flexible Leiterplatten mit nur einer Lage Leiterbahnen sind besonders einfach und kostengünstig herstellbar. Flexible Leiterplatten mit mehreren Lagen Leiterbahnen weisen hingegen den Vorteil auf, dass sich darauf komplexere Schaltungen anordnen und stärker integrieren lassen.

Durch die Auslagerung von Bauteilen sind auf der flexiblen Leiterplatte unter Umständen zusätzliche Leiterbahnen notwendig. Um eine Entflechtung von Schaltungsteilen vorzunehmen, können Kreuzungen von Leiterbahnen auf der flexiblen Leiterplatte mittels Bondverbindungen überbrückt werden.

Die flexible Leiterplatte kann auch aus mehreren flexiblen Teilplatten bestehen, welche miteinander verbunden sind. Eine mehrteilige Leiterplatte lässt sich einfacher einbauen. Zudem weist eine solche mehrteilige Leiterplatte den Vorteil auf, dass eine Grundausstattung mit Varianten erweitert werden kann, wobei zusätzliche Komponenten einer Variante auf einer Teilplatte untergebracht werden kann. Eine Erweiterung der Grundausstattung bedarf in diesem Fall nur noch des Einbaus der entsprechenden Teilplatte.

Die Erfindung wird nachfolgend anhand der Zeichnung beispielsweise näher erläutert. Dabei zeigen:
- Figur 1: Aufbau einer herkömmlichen flexiblen Leiterplatte im Grundriss,
- Figur 2: Aufbau einer herkömmlichen Getriebesteuerung im Grundriss,
- Figur 3: Gegenüberstellung einer herkömmlichen Getriebesteuerung mit einer ersten Ausführungsform der Erfindung im Seitenriss
- Figur 4: Steuereinheit in einer weiteren Ausführungsform der Erfindung im Grundriss.

Figur 3 zeigt eine Gegenüberstellung einer herkömmlichen Steuereinheit mit einer ersten Ausführungsform der Erfindung im Seitenriss. Über Bond-Verbindungen 9 ist die flexible Leiterplatte 3 mit einer starren Leiterplatte 5 verbunden. Die starre Leiterplatte 5 ist mit elektrisch isolierendem Wärmeleitkleber auf einer Grundplatte aus Aluminium, welche sich über die starre Leiterplatte 5 hinaus erstreckt, auflaminiert. Ebenso ist die flexible Leiterblatte 3 über den Bereich, welcher sich über die Grundplatte 10 erstreckt, dicht auflaminiert. Ein Deckel 12 ist mittels einer Dichtung 14, welche die starre Leiterplatte 5 umschließt, mit der Grundplatte, auf welche die flexible Leiterplatte laminiert ist fest verbunden, beispielsweise durch Nieten oder Schrauben, sodass ein dichtes Gehäuse durch die Grundplatte 10 und den Deckel 12 gebildet wird.

Nach dem Stand der Technik ist die starre Leiterplatte 5 mit sämtlichen elektrischen Bauteilen 7 bestückt. In einer ersten Ausführungsform der Erfindung ist ein Bauteil 7' auf der flexiblen Leiterplatte innerhalb des Gehäuses angelötet.

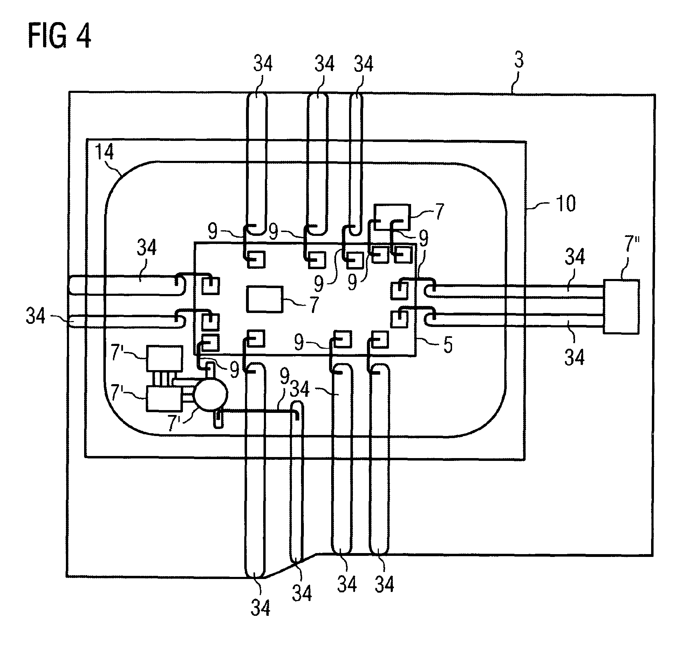

Figur 4 zeigt Steuereinheit 1 mit einer starren 5 und einer flexiblen 3 Leiterplatte in einer weiteren Ausführungsform der Erfindung. Die starre Leiterplatte 5 ist auf einer Grundplatte 10 befestigt. Die flexible Leiterplatte 3 mit Leiterbahnen 34 ist über Bondverbindungen 9 an die starre Leiterplatte 5 angeschlossen. Elektronische Bauteile 7, 7', 7" sind nicht nur auf der starren Leiterplatte 5, sondern auch auf der flexiblen Leiterplatte 3 angeordnet. Die flexible Leiterplatte 3 ist mittels einer Dichtung 14 durch ein öldichtes Gehäuse hindurchgeführt. Elektronische Bauteile 7', 7'', wie Kondensatoren, Transistoren, elektrische Widerstände, Spannungsregler und Sensoren sind auf der flexiblen Leiterplatte 3 innerhalb und außerhalb des öldichten Gehäuses angeordnet. Die flexible Leiterplatte 3 verfügt über Leiterbahnen 34, welche mittels Bondverbindungen 9 mit der starren Leiterplatte 5 verbunden sind und/oder an welche die auf der flexiblen Leiterplatte 3 angeordneten Bauteile 7', 7" angeschlossen sind. Um Leiterbahnen 34 auf der flexiblen Leiterplatte 3 zu überbrücken, sind ebenfalls Bondverbindungen 9 angebracht.

## Patentansprüche

1. Steuereinheit für eine Fahrzeugkomponente umfassend eine flexible Leiterplatte (3) und
eine starre Leiterplatte (5) welche mit elektronischen Bauteilen (7) bestückt ist,
wobei die flexible Leiterplatte (3) mit der starren Leiterplatte (5) elektrisch verbunden ist,
die starre Leiterplatte und ein Teil der flexiblen Leiterplatte (3) in einem Gehäuse angeordnet sind und
die flexible Leiterplatte (3) durch das Gehäuse hindurchgeführt ist
**dadurch gekennzeichnet, dass**
die flexible Leiterplatte (3) im Innern des Gehäuses mit elektronischen Bauteilen (7') bestückt ist.

2. Steuereinheit nach Anspruch 1,
**dadurch gekennzeichnet, dass**
die flexible Leiterplatte (3) außerhalb des Gehäuses mit elektronischen Bauteilen (7") bestückt ist.

3. Steuereinheit nach einem der vorangehenden Ansprüche
**dadurch gekennzeichnet, dass**
die flexible Leiterplatte (3) mit einem oder mehreren Kondensatoren und/oder einem oder mehreren Transistoren und/oder einem oder mehreren Widerständen und/oder einem oder mehreren Spannungsreglern und/oder einem oder mehreren Sensoren, insbesondere Hallsensoren, bestückt ist.

4. Steuereinheit nach einem der vorangehenden Ansprüche
**dadurch gekennzeichnet, dass**
das Gehäuse öldicht ist und die flexible Leiterplatte (3) öldicht durch das Gehäuse hindurchgeführt ist.

5. Steuereinheit nach einem der vorangehenden Ansprüche
**dadurch gekennzeichnet, dass**
die flexible Leiterplatte (3) eine isolierende Basisschicht und eine isolierende Deckschicht umfasst, wobei die Deckschicht Aussparungen aufweist, auf welchen Bauteile (7', 7") angeordnet sind.

6. Steuereinheit nach einem der vorangehenden Ansprüche
**dadurch gekennzeichnet, dass**
die flexible Leiterplatte (3) genau eine Lage mit Leiterbahnen (34) umfasst.

7. Steuereinheit nach einem der vorangehenden Ansprüche
**dadurch gekennzeichnet, dass**
die flexible Leiterplatte (3) mehrere Lagen mit Leiterbahnen (34) umfasst.

8. Steuereinheit nach Anspruch 6 oder 7
**dadurch gekennzeichnet, dass**
mindestens eine der Leiterbahnen (34) auf der flexiblen Leiterplatte (3) mittels einer Bondverbindung (9) überbrückt ist.

9. Steuereinheit nach einem der vorangehenden Ansprüche
**dadurch gekennzeichnet, dass**
die flexible Leiterplatte (3) mehrteilig ist.

10. Steuereinheit nach einem der vorangehenden Ansprüche
**dadurch gekennzeichnet, dass**
die Steuereinheit eine Steuereinheit für Fahrzeuggetriebe ist.

## Claims

1. Control unit for a vehicle component, comprising a flexible circuit board (3) and
a rigid circuit board (5) having electronic components (7), wherein the flexible circuit board (3) is electrically connected to the rigid circuit board (5),
the rigid circuit board and part of the flexible circuit board (3) are disposed in a housing and
the flexible circuit board (3) runs through the housing, **characterised in that**
the flexible circuit board (3) has electronic components (7') disposed inside the housing.

2. Control unit according to claim 1,
**characterised in that**
the flexible circuit board (3) has electronic components (7") disposed outside the housing.

3. Control unit according to one of the preceding claims,
**characterised in that**
the flexible circuit board (3) has one or more capacitors and/or one or more transistors and/or one or more resistors and/or one or more voltage regulators and/or one or more sensors, in particular Hall sensors.

4. Control unit according to one of the preceding claims,
**characterised in that**
the housing is oil-tight and the flexible circuit board (3) runs through the housing in an oil-tight manner.

5. Control unit according to one of the preceding claims,
**characterised in that**
the flexible circuit board (3) has an insulating base layer and an insulating cover layer, said cover layer having recesses on which components (7', 7") are disposed.

6. Control unit according to one of the preceding claims,
**characterised in that**
the flexible circuit board (3) has a single layer with traces (34).

7. Control unit according to one of the preceding claims,
**characterised in that**
the flexible circuit board (3) has a plurality of layers with traces (34).

8. Control unit according to claim 6 or 7,
**characterised in that**
at least one of the traces (34) on the flexible circuit board (3) is bridged by a wire bond (9).

9. Control unit according to one of the preceding claims,
**characterised in that**
the flexible circuit board (3) is a multi-part flexible circuit board.

10. The control unit according to one of the preceding claims,
**characterised in that**
the control unit is a control unit for motor vehicle transmissions.

## Revendications

1. Unité de commande pour un élément de véhicule comprenant une carte de circuits imprimés souple (3) et
une carte de circuits imprimés rigide (5) qui est équipée de composants électroniques (7),
dans laquelle la carte de circuits imprimés souple (3) est électriquement connectée à la carte de circuits imprimés rigide (5),
la carte de circuits imprimés rigide et une partie de la carte de circuits imprimés souple (3) sont agencées dans un boîtier, et
la carte de circuits imprimés souple (3) est passée à travers le boîtier,
**caractérisée en ce que**
la carte de circuits imprimés souple (3) est équipée à l'intérieur du boîtier de composants électroniques (7').

2. Unité de commande selon la revendication 1, **caractérisée en ce que**
la carte de circuits imprimés souple (3) est équipée à l'extérieur du boîtier de composants électroniques (77").

3. Unité de commande selon l'une quelconque des revendications précédentes,
**caractérisée en ce que**
la carte de circuits imprimés souple (3) est équipée d'un ou plusieurs condensateurs et/ou d'un ou plusieurs transistors et/ou d'une ou plusieurs résistances et/ou d'un ou plusieurs régulateurs de tension et/ou d'un ou plusieurs capteurs, en particulier des capteurs à effet Hall.

4. Unité de commande selon l'une quelconque des revendications précédentes,
**caractérisée en ce que**
le boîtier est étanché à l'huile et la carte de circuits imprimés souple (3) est passée de manière étanche à l'huile à travers le boîtier.

5. Unité de commande selon l'une quelconque des revendications précédentes,
**caractérisée en ce que**
la carte de circuits imprimés souple (3) comprend une couche de base isolante et une couche de recouvrement isolante, la couche de recouvrement présentant des évidements, sur lesquels des composants (7', 7") sont agencés.

6. Unité de commande selon l'une quelconque des revendications précédentes,
**caractérisée en ce que**
la carte de circuits imprimés souple (3) comprend exactement une couche avec des pistes conductrices (34).

7. Unité de commande selon l'une quelconque des revendications précédentes,
**caractérisée en ce que**
la carte de circuits imprimés souple (3) comprend plusieurs couches avec des pistes conductrices (34).

8. Unité de commande selon la revendication 6 ou 7,
**caractérisée en ce que**
au moins un des pistes conductrices (34) est pontée sur la carte de circuits imprimés souple (3) au moyen d'une connexion de soudage (9).

9. Unité de commande selon l'une quelconque des revendications précédentes,
**caractérisée en ce que**
la carte de circuits imprimés souple (3) est formée de plusieurs pièces.

10. Unité de commande selon l'une quelconque des revendications précédentes,
**caractérisée en ce que**
l'unité de commande est une unité de commande pour transmission de véhicule.
